# EUROPEAN PATENT APPLICATION

(11) **EP 4 779 053 A1**
(43) Date of publication of application: **22.07.2026**
(21) Application number: 24956894.0
(22) Date of filing: 10.10.2024
(51) Int. Cl.: C23C 16/448, B01J 7/02, H10P 14/60

(54) **VAPORIZER**

(71) Applicant: Lintec Co., Ltd., Otsu-shi, Shiga 520-2277 (JP)
(72) Inventor: ONO, Hirofumi, Otsu-shi, Shiga 520-2277 (JP); YAMAMOTO, Kenta, Otsu-shi, Shiga 520-2277 (JP); YAGI, Shigeo, Otsu-shi, Shiga 520-2277 (JP)
(74) Representative: HGF
(86) International application number: PCT/JP2024/036311
(87) International publication number: WO 2026/078850

(57) **Abstract**

A vaporizer 10 includes a vaporizer body 20, spheres 30, and a heater H. The vaporizer body 20 includes a liquid material supply unit 12 that supplies a liquid material LM, a vaporization unit 22 having therein a vaporization space K for vaporizing the liquid material LM, and a source gas discharge unit 40 that feeds a source gas VG obtained through vaporization to a subsequent step. The spheres 30 are loaded in the vaporization unit 22. The heater H emits infrared radiation. The heater H is disposed with a gap d1 from the vaporization unit 22. The vaporization unit 22 and the spheres 30 are formed of infrared-transmissive transparent members. A liquid pool E into which the liquid material LM flows is provided in the vaporization unit 22 so as to be positioned lower than flow paths R of the liquid material LM flowing through the vaporization space K.

## Description

### Technical Field

The present invention relates to a vaporizer capable of efficiently and reliably vaporizing a liquid material which is used in a process of manufacturing a semiconductor.

### Background Art

In the process of manufacturing a semiconductor, there is a device that vaporizes a liquid material to perform a film deposition process such as an oxide film or thin film formation step, and that supplies the resulting source gas to the subsequent processing device. A vaporizer is used to vaporize a liquid material that is controlled at a constant flow rate and to supply the resulting source gas to the subsequent processing device.

For example, in the oxide film formation step, in order to form an oxide film on a surface of a silicon wafer, a source gas (specifically, oxidizing gas such as water vapor or hydrogen peroxide vapor) for forming the oxide film is supplied into a high-temperature oxidation furnace to perform an oxide film formation process. In addition, examples of an organic compound used include TEOS (tetraethoxysilane) and its derivative PhTES (phenyltriethoxysilane).

In this film deposition process, it is necessary that the vaporizer reliably feeds the source gas at the temperature and flow rate required by the processing device. Generally, in the film deposition step, the flow rate of the source gas is varied.

In the vaporizer, the heat energy for vaporizing a liquid material needs to be varied in response to variations in the flow rate of the liquid material. Thus, the power supplied to a heater needs to be controlled.

In addition, it is also required that the vaporizer completely vaporizes the supplied liquid material and supplies the same in a steady state to the subsequent processing device. In this case, even if complete vaporization of the liquid material is achieved, it is also necessary that the device does not become excessively large.

A conventional vaporizer (in Patent Literature 1) includes a tubular metal housing extending in the up-down direction, a metal disk that is installed to close off the metal housing and that has numerous micropores penetrating from the front surface to the back surface, a liquid material supply nozzle that is disposed vertically so as to face the disk and through which a liquid material is supplied onto a surface of the disk, and a heater that is provided on the outer periphery of the housing and that heats the housing and the disk. In this vaporizer, the liquid material is dripped onto the surface of the disk through the liquid material supply nozzle, and the dripped liquid material spreads across the entire surface of the disk due to surface tension and is vaporized efficiently due to the heated disk. The resulting vapor-phase source gas is carried by the carrier gas supplied into the housing from above and flows downward through the micropores of the disk.

However, in this vaporizer, for example, when a liquid material including an organic compound is vaporized, a residue that has not been vaporized remains on the surface of the disk and gradually clogs the numerous micropores formed in the disk. Eventually, due to such clogging, the amount of the liquid material that can be vaporized is reduced, and ultimately, clogging prevents vaporization. In other words, once clogging occurs, the supplied liquid material cannot be vaporized fully and accurately within the prescribed time, and the source gas cannot be reliably supplied to the processing device. Then, a vaporizer disclosed in Patent Literature 2 is proposed.

In the vaporizer disclosed in Patent Literature 2, two housings, inner and outer ones obtained by dividing the housing disclosed in Patent Literature 1, are provided, numerous opaque granules made of ceramic or corrosion-resistant metal are housed in the inner housing, and numerous holes having diameters larger than the micropores formed in the disk in Patent Literature 1 are formed in the bottom of the inner housing. The portion in which the granules are housed serves as a vaporization unit for a liquid material. The housing and the granules, as a whole, are primarily heated by thermal conduction from the heater.

A liquid material is supplied in the form of droplets onto the granules through the liquid material supply nozzle, and flows downward through voids between the granules in one or more streams while wetting the surfaces of the granules. Since the granules are heated via the housing, the liquid material is gradually vaporized while flowing downward and wetting the surfaces of the granules.

A carrier gas is supplied from above into the housing, and flows downward through the voids between the granules. While flowing, the carrier gas carries the resulting vapor-phase source gas, flows downward through the holes in the bottom of the inner housing, and flows toward the subsequent processing device. The heater is controlled such that the liquid material is completely vaporized before reaching the bottom of the housing. As described above, in this vaporizer, the granules are used as a vaporization layer, and the holes in the bottom are formed to be larger than the micropores in Patent Literature 1, thereby eliminating clogging in the micropores, which is a problem with respect to the vaporizer disclosed in Patent Literature 1.

### Citation List

### [Patent Literature]

[PTL 1] US Patent No. 5711816
[PTL 2] Japanese Laid-Open Patent Publication No. 2001-295050

### Summary of Invention

### Technical Problem

In the vaporizer disclosed in Patent Literature 2, the vaporization unit is composed of the opaque spheres, and the holes in the bottom are formed to be larger than micropores in Patent Literature 1. Thus, the occurrence of clogging in the vaporizer disclosed in Patent Literature 1 has been eliminated. However, the vaporizer disclosed in Patent Literature 2 cannot flexibly respond to variations in the feed rate of the liquid material.

That is, as described above, this vaporizer includes the vaporization unit in which the opaque spheres are loaded, and the supplied liquid material is fully vaporized while flowing downward through the vaporization unit. However, if the feed rate of the liquid material is increased and becomes excessive relative to the heat output of the heater, the unvaporized liquid material leaks out directly through the holes in the bottom. The liquid fails to be vaporized, leading to poor film deposition.

Conversely, when the vaporization unit is configured so as to correspond to the feed rate of the liquid material, the vaporization unit must be sized so as to correspond to the highest feed rate thereof, and thus, the vaporizer itself may be oversized. On the other hand, when the shape of the vaporizer is limited, the highest feed rate of the liquid material must be limited.

In other words, the vaporizer disclosed in Patent Literature 2 cannot vaporize a large amount to liquid material, thereby making it difficult to respond flexibly to variations in the required amount of gas.

In addition, a thermocouple is usually installed in the housing for temperature control of the heater. However, the liquid material flows downward in one or more streams through the layer composed of the spheres. If the thermocouple is installed near a low-temperature stream of the liquid material, the detected temperature indicates a lower temperature, so that the heater is overheated. As a result, the temperature of a source gas supplied to the processing device is higher than the required temperature, which also has a negative impact on the liquid material.

In addition, in the vaporizer disclosed in Patent Literature 2, since the opaque spheres are heated primarily by thermal conduction from the inner housing, the spheres in the peripheral region in contact with the inner housing reach a high temperature near that of the inner housing, while the spheres in the center region poorly receive heat and remain cooler, so that temperature non-uniformity is generated between the inner and outer regions in the inner housing. As described above, the flow paths of the liquid material flowing in the layer composed of the spheres are not constant, and may pass in the center region or in the peripheral region, so that the vaporization state fluctuates depending on the flow paths of the liquid material. Such fluctuations hinder the source gas from being supplied to the processing device in a steady state.

The present invention has been made in view of such conventional problems. The first object of the present invention is to allow a source gas to be supplied flexibly in response to variations in the amount of the source gas required by a processing device, to allow the supplied liquid material to be completely vaporized without causing clogging and prevent the generation of any unvaporized liquid material, and to provide a vaporizer capable of steadily supplying the source gas at a required temperature to a processing device. The second object thereof is to provide a vaporizer in which temperature measurement of a heater is accurately performed in order to achieve the first object.

### Solution to Problem

In order to solve the above problems, the present invention (claim 1) provides a vaporizer 10 configured as follows.

A vaporizer 10 includes:
a vaporizer body 20 that includes a liquid material supply unit 12 that supplies a liquid material LM for semiconductor manufacturing, a vaporization unit 22 that has therein a vaporization space K for vaporizing the supplied liquid material LM, and a source gas discharge unit 40 that feeds a source gas VG obtained through vaporization to a subsequent step;
spheres 30 that are loaded in the vaporization unit 22; and
a heater H that emits infrared radiation to vaporize the liquid material LM.

The heater H is disposed so as to be spaced from the vaporization unit 22 by a gap d1 having a width M1.

The vaporization unit 22 and the spheres 30 are formed of transparent members that transmit infrared radiation.

A liquid pool E into which the liquid material LM flows is provided in the vaporization unit 22 so as to be positioned lower than flow paths R of the liquid material LM flowing through the vaporization space K.

According to claim 2, in the vaporizer 10 according to claim 1, the vaporization unit 22 is formed of a bent tube member.

According to claim 3, in the vaporizer 10 according to claim 1, the vaporizer 10 includes a reflective member 28 that is disposed outside the heater H so as to enclose the vaporization unit 22, and that has an inner surface facing the vaporization unit 22 and formed as a mirror surface 28k that reflects infrared radiation.

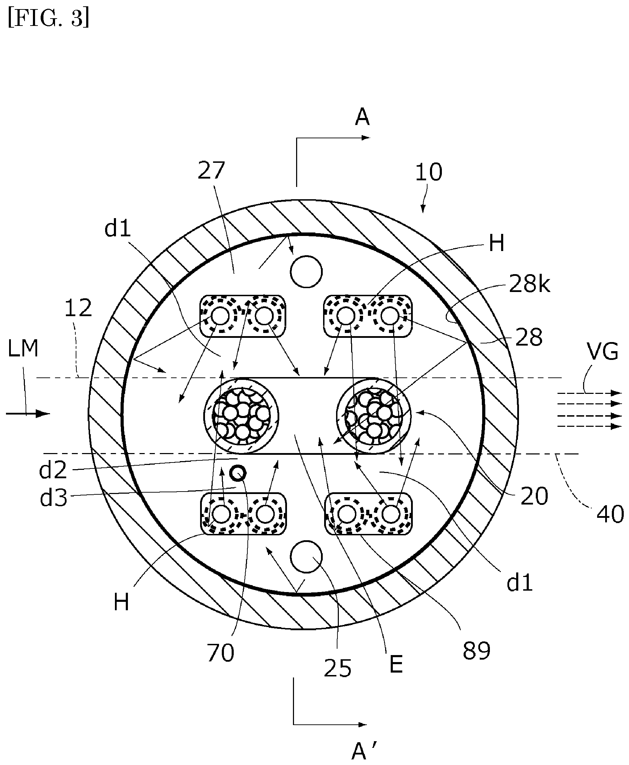

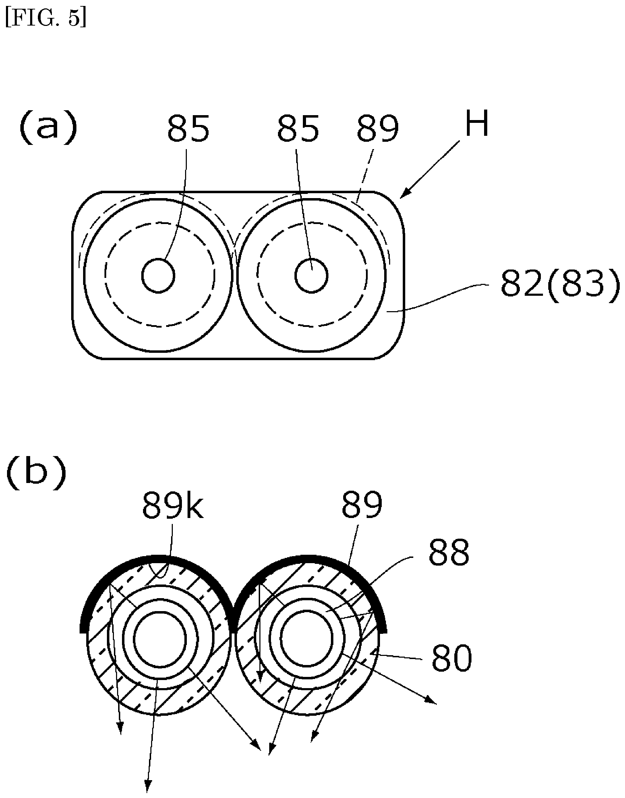

According to claim 4, an auxiliary reflective member 89 is provided on the heater H (FIG. 3, FIG. 5).

In the vaporizer 10 according to claim 1 or 3, the auxiliary reflective member 89 is provided on a surface of the heater H that faces away from the vaporizer body 20, and a surface of the auxiliary reflective member 89 that reflects infrared radiation toward the vaporizer body 20 is a mirror surface 89k.

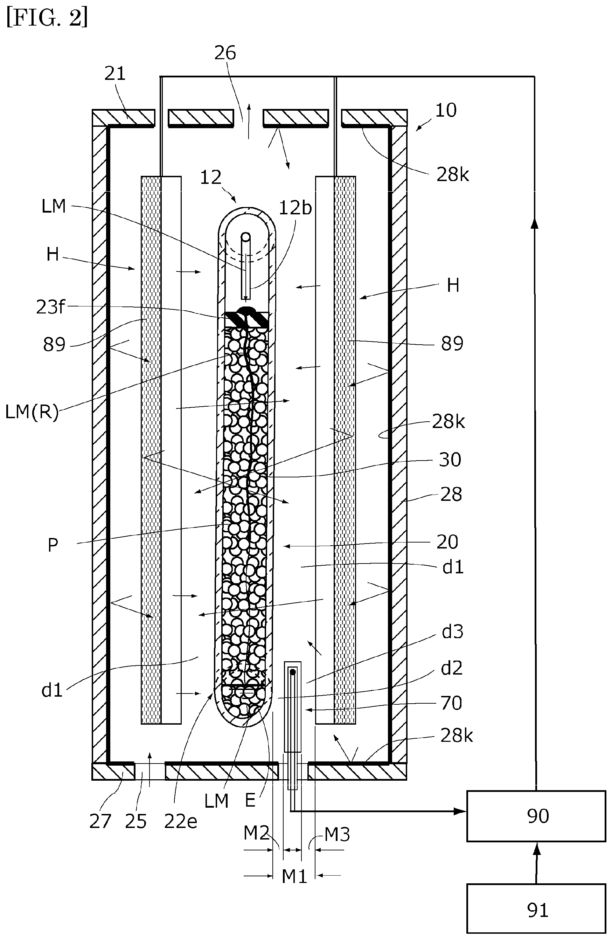

Claim 5 relates to the arrangement of a temperature detector 70 (FIG. 2).

In the vaporizer 10 according to claim 1 or 3,
the temperature detector 70 that measures an amount of infrared radiation is disposed between the vaporization unit 22 and the heater H such that gaps d2, d3 having widths M2, M3 are provided between the temperature detector 70 and the vaporizer body 20 and between the temperature detector 70 and the heater H.

Claim 6 relates to the specific structure of the temperature detector 70 (FIG. 2).

In the vaporizer 10 according to claim 5,
the temperature detector 70 includes an infrared absorber 78 that is made of graphite and that is heated by absorbing infrared radiation, and a temperature sensing element 71 that is embedded in the infrared absorber 78 and that detects temperature of the infrared absorber 78.

### Advantageous Effects of Invention

According to the present invention (claim 1), since the vaporization unit 22 and the spheres 30 are formed of transparent members that transmit infrared radiation, the infrared radiation emitted by the heater H passes entirely through the vaporization unit 22 and the spheres 30. As a result, the liquid material LM supplied into the vaporization unit 22 is uniformly and directly heated by infrared radiation while flowing downward between the spheres 30, regardless of which flow paths R the liquid material LM follows.

The liquid pool E is provided in the vaporization unit 22 so as to be positioned lower than the flow paths R of the liquid material LM flowing through the vaporization space K. When the feed rate of the liquid material LM supplied from the liquid material supply unit 12 is high and the liquid material LM is not fully vaporized before reaching the liquid pool E, the unvaporized portion of the liquid material LM accumulates in the liquid pool E. The unvaporized liquid material LM that accumulates in the liquid pool E is heated therein and efficiently and sequentially vaporized, without leaking out from the liquid pool E.

Therefore, a large amount of the liquid material LM can be efficiently treated by the vaporization unit 22 having a small capacity, thereby allowing flexible response to fluctuations in the feed rate of the liquid material LM.

In the present invention (claim 2), since the vaporization unit 22 is formed of the bent tube member, the bent portion 22e serves as the liquid pool E, thereby allowing the vaporizer 10 to flexibly respond to fluctuations in the feed rate of the liquid material LM.

According to the present invention (claim 3), since the infrared radiation emitted by the heater H is repeatedly reflected in countless and random directions by the reflective member 28 enclosing the vaporization unit 22, the transparent vaporizer body 20 and the transparent spheres 30 are uniformly exposed to infrared radiation throughout. Then, the liquid material LM flowing downward in streams through voids between the transparent spheres 30, is mainly vaporized smoothly through efficient absorption of the infrared radiation.

According to the present invention (claim 4), the infrared radiation emitted by the heater H toward the side facing away from the vaporizer body 20 is reflected by the auxiliary reflective member 89 toward the vaporizer body 20, so that the infrared radiation emitted by the heater H and reflected by the auxiliary reflective member 89 is also concentrated toward the vaporizer body 20.

According to the present invention (claim 5), since the temperature detector 70 is disposed so as to be in contact with neither the vaporization unit 22 nor the heater H, the temperature detector 70 can perform temperature detection without being affected by either the vaporization unit 22 or the heater H. The temperature detection by the temperature detector 70 relies solely on the infrared radiation absorbed by the temperature detector 70, thereby improving the accuracy of the temperature detection.

According to the present invention (claim 6), since graphite, which has a high absorptivity for infrared radiation and high thermal conductivity, is used as the infrared absorber 78 of the temperature detector 70, the infrared radiation that has entered the infrared absorber 78 is almost entirely absorbed and converted to heat, and the amount of the infrared radiation emitted by the heater H can be accurately and rapidly measured.

### Brief Description of Drawings

[FIG. 1] FIG. 1 is a longitudinal cross-sectional view of a vaporizer (embodiment 1) according to the present invention as viewed from the front.
[FIG. 2] FIG. 2 is a sectional view taken along a line A-A' in FIG. 3.
[FIG. 3] FIG. 3 is a sectional view taken along a line B-B' in FIG. 1.
[FIG. 4] FIG. 4(a) is a longitudinal cross-sectional view of a heater used in the vaporizer according to the present invention, and FIG. 4(b) is a partial longitudinal cross-sectional view of another heater.
[FIG. 5] FIG. 5(a) is a plan view of the heater, and FIG. 5(b) is a sectional view taken along a line C-C' in FIG. 4(a).
[FIG. 6] FIG. 6(a) is a longitudinal cross-sectional view of a temperature detector used in the vaporizer according to the present invention, and FIG. 6(b) is a plan view thereof.
[FIG. 7] FIG. 7(a) is a partially enlarged view with respect to gaps between the temperature detector and the heater and between the vaporizer body and the heater, and FIG. 7(b) is a partially enlarged view with respect to a gap between the vaporizer body and the heater.
[FIG. 8] FIG. 8(a) is a partially enlarged sectional view of a straight tube portion of a vaporization unit, and FIG. 8(b) is a partially enlarged sectional view of a bent portion thereof.
[FIG. 9] FIG. 9 is a partial longitudinal cross-sectional view of another example of a liquid supply unit of the vaporizer according to the present invention.
[FIG. 10] FIG. 10 is a longitudinal cross-sectional view of the vaporizer according to an embodiment 2 of the present invention.
[FIG. 11] FIG. 11 is a sectional view taken along a line D-D' in FIG. 10.
[FIG. 12] FIG. 12 is a longitudinal cross-sectional view of the vaporizer body according to an embodiment 3 of the present invention.
[FIG. 13] FIG. 13 is a longitudinal cross-sectional view of the vaporizer body according to an embodiment 4 of the present invention.
[FIG. 14] FIG. 14 is a longitudinal cross-sectional view of the vaporizer body according to an embodiment 5 of the present invention.
[FIG. 15] FIG. 15 is a longitudinal cross-sectional view of the vaporizer body according to an embodiment 6 of the present invention.

### Description of Embodiments

Hereinafter, the present invention will be described with reference to the drawings. A vaporizer 10 is a device that vaporizes a liquid material LM supplied from the upstream side to generate a source gas VG, and supplies the source gas VG to various semiconductor manufacturing apparatuses on the downstream side that use the source gas VG.

The vaporizer 10 is mainly composed of a vaporizer body 20, a heater H, a temperature detector 70, and a reflective member 28 that serves as a casing for housing these components.

As described above, there are a variety of liquid materials LM, and an appropriate liquid material LM is selected based on the type of source gas VG to be used in each semiconductor manufacturing apparatus. Here, the representative examples include water, hydrogen peroxide, TEOS (tetraethoxysilane), and PhTES (phenyltriethoxysilane).

These liquid materials LM efficiently absorb mid-infrared radiation in the wavelength range of 2.5 µm to 4 µm. In the case of water, a film thickness equal to or larger than 10 µm allows efficient absorption of mid-infrared radiation in this range. A film thickness of 1 mm allows absorption of approximately 100% of the mid-infrared radiation in this range.

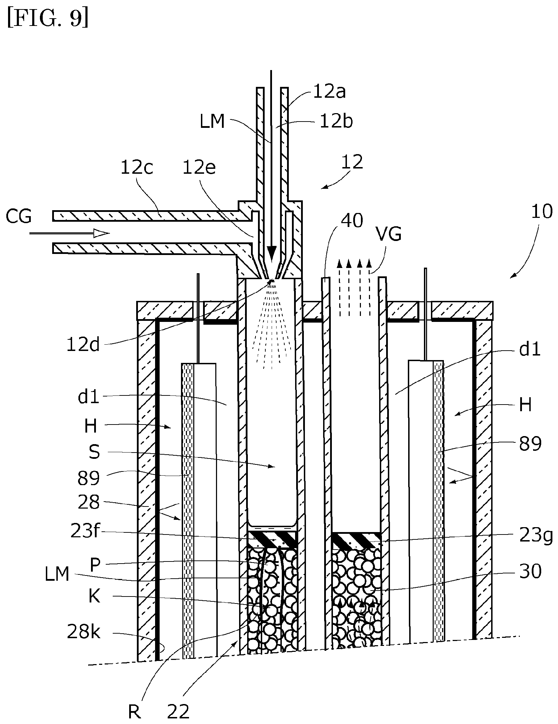

The liquid material LM is supplied into the vaporizer body 20 in the form of mist, droplets, or liquid. A carrier gas CG may be supplied together with the liquid material LM into the vaporizer body 20, or only the liquid material LM may be supplied into the vaporizer body 20 without the carrier gas CG. When the liquid material LM is supplied into the vaporizer body 20 in the form of mist, an atomizer 12a or the like is used (FIG. 9).

In order to achieve the above-described objects, the vaporizer body 20 may have various configurations. A common feature among these configurations is that a liquid pool E into which the liquid material LM flows is provided in the vaporization unit 22 so as to be positioned lower than the flow paths R of the liquid material LM flowing through a vaporization space K.

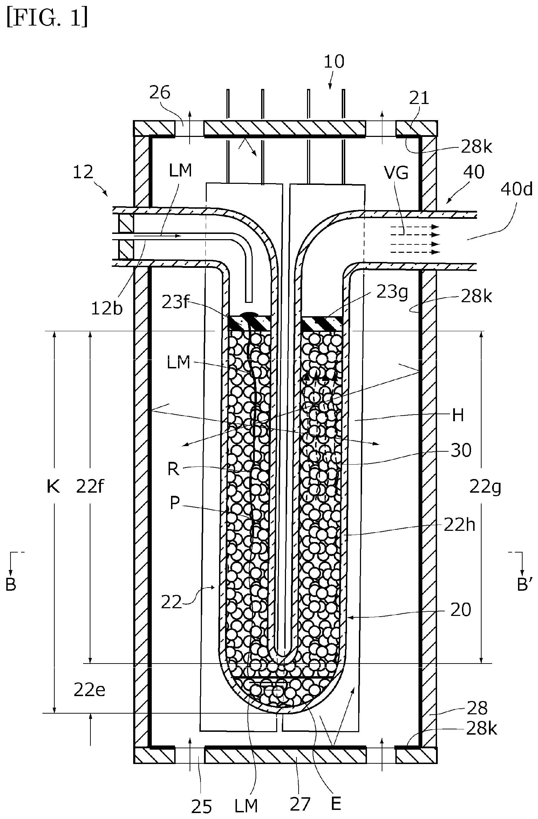

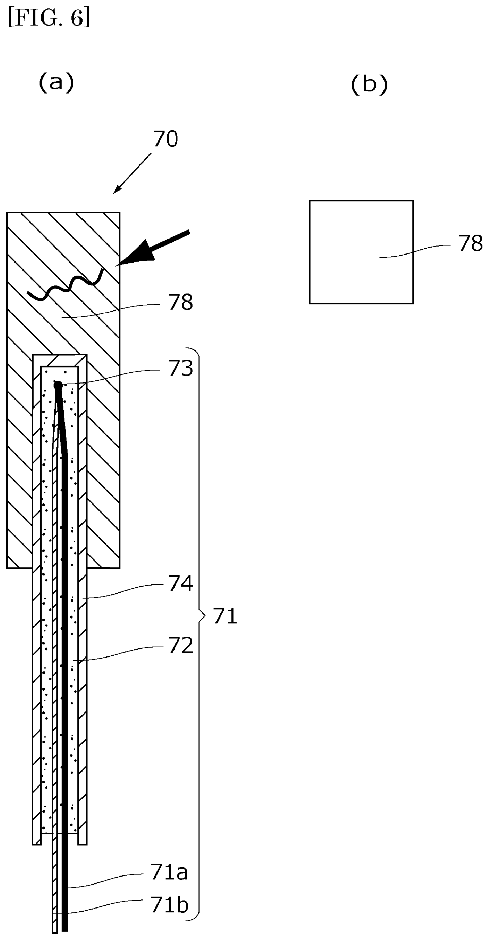

### (Embodiment 1: FIG. 1 to FIG. 8)

In the vaporizer 10 of an embodiment 1, the liquid material LM is supplied in the form of liquid or droplets into the vaporizer body 20. The vaporizer body 20 includes a liquid material supply unit 12 that supplies the liquid material LM into the vaporization space K, the vaporization unit 22 that has therein the vaporization space K in which the supplied liquid material LM is vaporized, and a source gas discharge unit 40 that feeds the source gas VG obtained through vaporization to the subsequent step.

In a case shown in FIG. 1, the vaporizer body 20 has an integrated structure in which the liquid material supply unit 12 and the source gas discharge unit 40 are combined with the vaporization unit 22. As a matter of course, as described below, the liquid material supply unit 12, the source gas discharge unit 40, and the vaporization unit 22 may also be separate components (FIG. 9).

The vaporizer body 20 is a member that transmits infrared radiation, for example, a member formed by bending a transparent quartz glass tube member having a circular cross-section.

In the present embodiment, the vaporization unit 22 is a portion bent into a U shape, and includes a bent portion 22e and straight tube portions 22f, 22g extending upward from the bent portion 22e.

The liquid material supply unit 12 is connected integrally to the straight tube portion 22f, as one of the straight tube portions, and is formed in an inverted L shape, and the inlet portion of the liquid material supply unit 12 extends in the horizontal direction. The source gas discharge unit 40 is connected integrally to a straight tube portion 22g, as the other of the straight tube portions, and the outlet portion of the source gas discharge unit 40 extends in the horizontal direction.

In the vaporization unit 22 formed in a U shape and including the bent portion 22e and the straight tube portions 22f, 22g, spheres 30 made of an infrared-transmissive material such as transparent quartz are loaded. Each sphere 30 is a sphere having a diameter of 2 mm to 5 mm, for example.

In the vaporization unit 22, a portion in which the spheres 30 are loaded is the vaporization space K.

The spheres 30 are in point contact with each other, and voids P are formed between the spherical surfaces of the spheres 30 so as to serve as the flow paths of the liquid material LM.

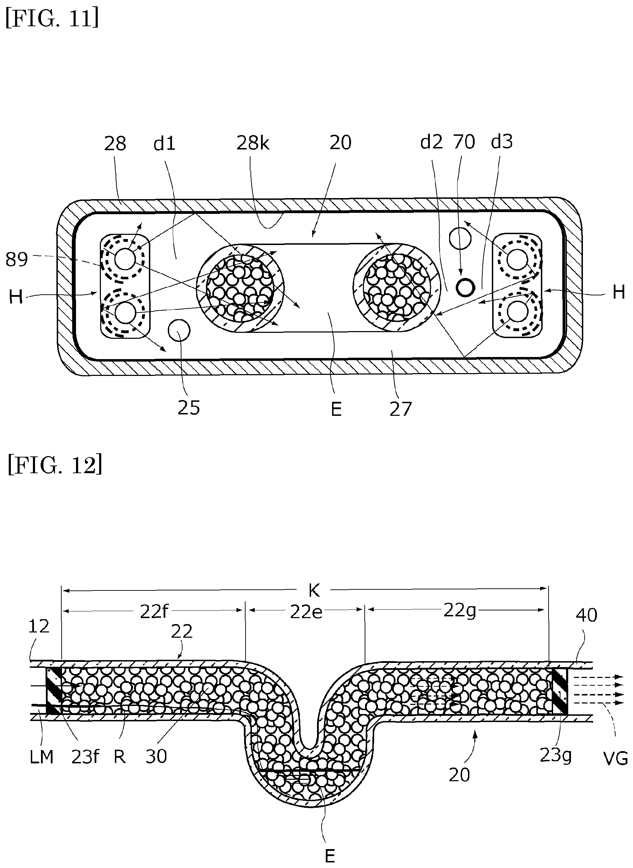

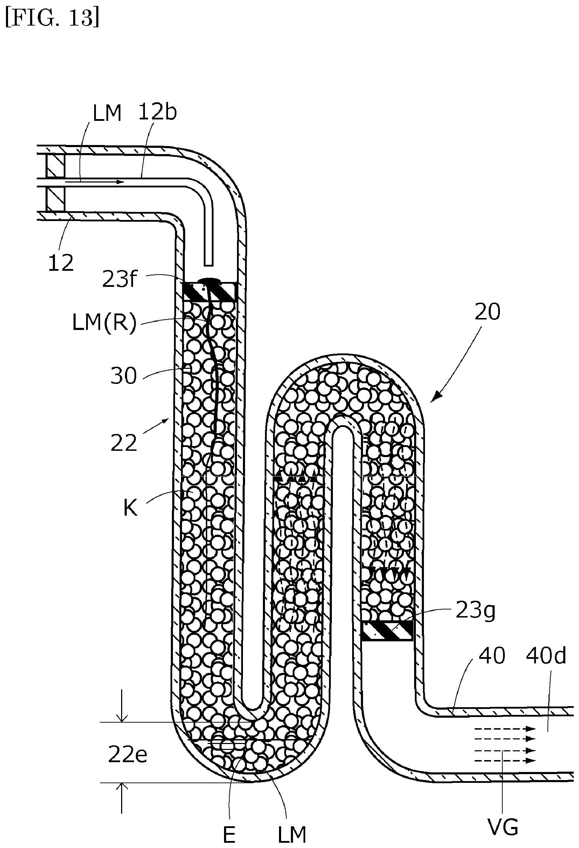

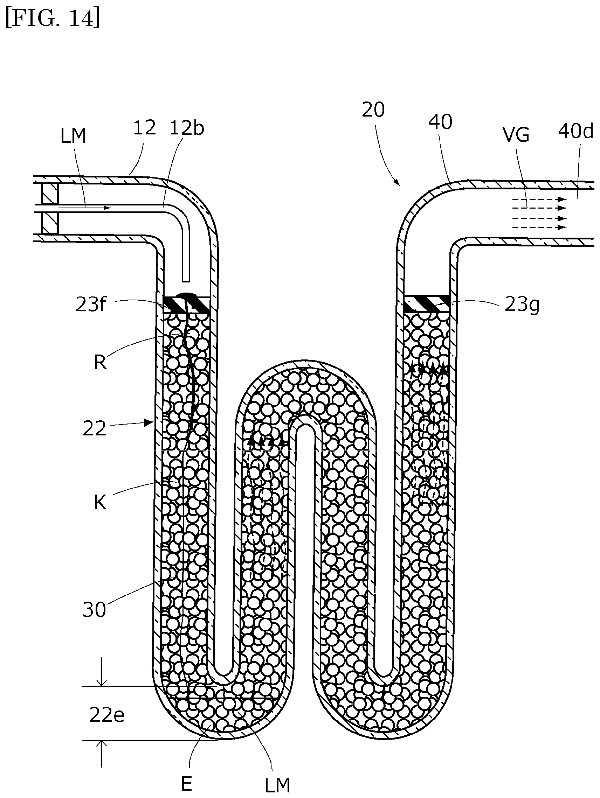

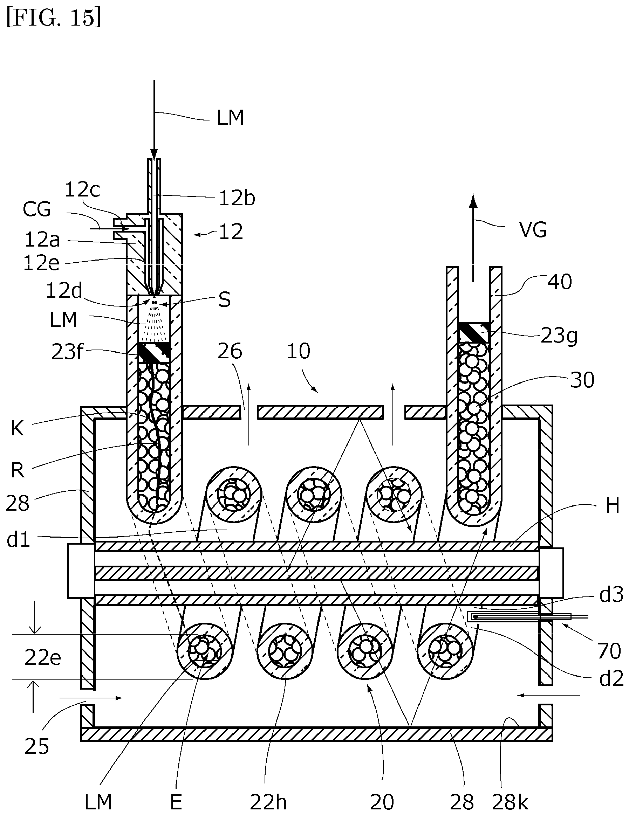

In the embodiment shown in FIG. 1, the vaporization unit 22 is bent into a U shape. However, the shape of the vaporization unit 22 is not limited to a U shape, as described below. The bent portion 22e forming the bottom of the vaporization unit 22 serves as the liquid pool E for the liquid material LM. In the present invention, it is sufficient that the liquid pool E is positioned lower than the flow paths R of the liquid material LM flowing through the vaporization space K. As described below, examples of the vaporization unit 22 include one in which the bent portion 22e is provided so as to be positioned between and lower than the straight tube portions 22f, 22g extending in the horizontal direction (FIG. 12), one having an approximately n-shaped configuration (FIG. 13), one having an approximately W-shaped configuration (FIG. 14), and one in which a helix tube is disposed in the horizontal orientation (FIG. 15).

Porous filters 23f, 23g are placed on the spheres 30 loaded in the straight tube portions 22f, 22g, as necessary. The porous filters 23f, 23g may be made of any material as long as the material is free from being affected by the liquid material LM and the liquid material LM can smoothly pass through the material. Here, in order to ensure that such a material can transmit the infrared radiation emitted by the heater H and can be welded and fixed to the vaporizer body 20, a semi-molten quartz glass porous body obtained by bonding quartz glass particulate material in a semi-molten state by melting at contact areas thereof, is used.

Although not shown, in order to maintain the discharged source gas VG at a constant temperature, a cylindrical heater block including a built-in heater may be mounted to the outer periphery of the tubular source gas discharge unit 40.

Transparent quartz glass is used as a material of the vaporizer body 20 and the spheres 30 because the transparent quartz glass is transmissive to the infrared radiation emitted by the heater H, so that the infrared radiation can penetrate to the center part of the vaporization unit 22.

Each sphere 30 has a spherical shape in the present embodiment. However, the present invention is not limited to the spheres 30 having spherical shapes, and quartz with a granular texture may be used, for example. The quartz with a granular texture has a larger surface area, which enhances the vaporization efficiency of the liquid material, and thus is preferable. However, any material that may be chipped by oscillation or other external force or that may cause particles to form is not used.

A plurality of heaters H (two heaters H in the present embodiment) are installed so as to stand on both sides of the vaporizer body 20. It is preferable that the straight tube portions 22f, 22g of the vaporization unit 22 and the heaters H are arranged so as to be parallel to each other such that the centerlines of the straight tube portions 22f, 22g and the centerlines of the heaters H are aligned in the front-rear direction and parallel to each other. The heaters H are configured such that at least the straight tube portions 22f, 22g and the bent portion 22e, which are the vaporization unit 22, lie within the effective range of the heaters H, and infrared radiation is emitted evenly onto the straight tube portions 22f, 22g and the bent portion 22e.

A gap d1 having a width M1 is provided between each heater H and a side wall 22h of the vaporizer body 20. By means of this, heat transfer from the heaters H to the vaporizer body 20 is blocked. However, since gas (air) is present in the gap d1, heat of the heater H is transferred to the vaporizer body 20. Therefore, as described below, it is conceivable that the gap d1 is used as a flow passage for replacing the gas.

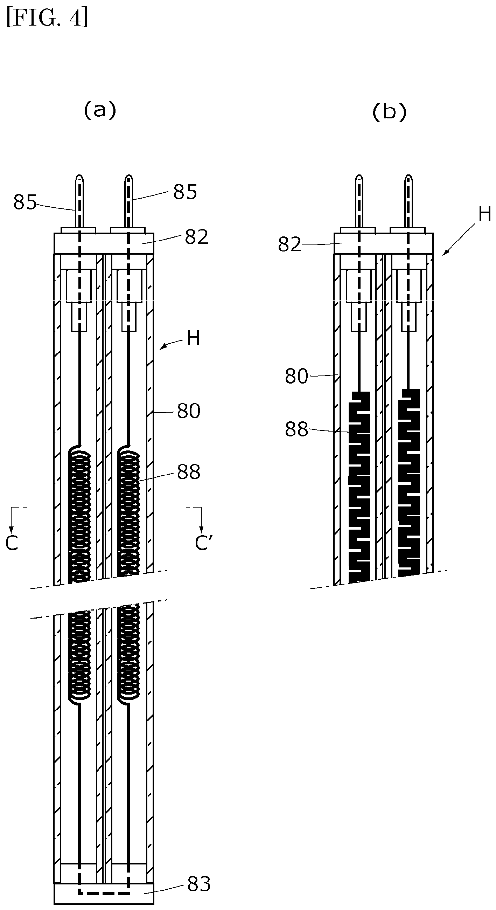

The heater H of a first example is as shown in FIG. 4(a). The heater H includes a pair of transparent quartz tubes 80, sealing insulators 82, 83 provided at both ends of the transparent quartz tubes 80, connection terminals 85 provided at the upper sealing insulator 82, heater coils 88 stretched inside the transparent quartz tubes 80, and an auxiliary reflective member 89. The heater coils 88 are made of Kanthal wire, for example. The pair of heater coils 88 are connected inside the sealing insulator 83 at the lower ends thereof. The upper ends of the heater coils 88 are respectively connected to the connection terminals 85. An inert gas is sealed inside the transparent quartz tubes 80.

When the heater coils 88 are made of Kanthal wire, the peak wavelength is 2.6 µm. The wavelengths at which the relative emissive power of the Kanthal wire is 50% or greater lie in the mid-infrared region of approximately 1.5 µm to 4 µm.

The heater H of a second example is shown in FIG. 4(b). In this case, each heater coil 88 is made of graphite processed into a zigzag shape. Graphite also emits infrared radiation similar to the Kanthal wire.

The heater H in FIG. 5(b) shows an example in which the auxiliary reflective member 89 is used. As described below, since the main reflective member 28 enclosing the vaporizer body 20 is provided, the auxiliary reflective member 89 is not necessarily needed. This auxiliary reflective member 89 is provided on the surfaces on the back-surface side of the transparent quartz tubes 80, that is, over the entire surfaces facing away from the side wall 22h of the vaporizer body 20, and has a surface that faces the vaporizer body 20 and that is the mirror surfaces 89k.

The reflective member 28 is a cylindrical member provided to reflect infrared radiation emitted by the heaters H toward the vaporization space K. The inner surface of the reflective member 28 is finished with a mirror surface 28k by means such as plating or vapor deposition with a metal having a high infrared reflectance (e.g., gold), or aluminum foil is adhered to the inner surface of the reflective member 28a to obtain the mirror surface 28k.

The reflective member 28 is disposed outside the heaters H so as to enclose the vaporizer body 20 as shown in FIG. 3. The upper end of the reflective member 28k is provided with a ceiling plate 21, and the lower end thereof is provided with a bottom plate 27. The inner surfaces of the ceiling plate 21 and the bottom plate 27 are also the mirror surfaces 28k.

A hole is formed in the bottom plate 27 to be used as a replacement-gas supply portion 25. A hole is also formed in the ceiling plate 21 to be used as a replacement-gas discharge portion 26. These holes allow replacement gas (air) to flow in an interior space of the reflective member 28 in which the heaters H are disposed. Accordingly, the gas (air) around and heated by the heaters H rises and is discharged through the replacement-gas discharge portion 26, and outside air at room temperature flows in through the replacement-gas supply portion 25 in place of the discharged gas, so that the temperature of the space in which the heaters H are disposed is maintained at the temperature of the replacement gas (air). As a result, as described below, most of the thermal impact caused by the heaters H in the interior space of the reflective member 28, on the vaporizer body 20 or the temperature detector 70, is eliminated.

FIG. 1 to FIG. 3 each show an example considering heat transfer to the vaporizer body 20 in the space in which the heaters H are disposed. Heating by the heaters H increases the temperature of gas (air) around the heaters H. The side wall 22h of the vaporizer body 20 is heated through this heated gas (air). Thus, a width M1 of the gap d1 is elaborately designed, and the gap d1 is used as a flow passage for replacement gas. This can be applied to all the embodiments.

In this case, the width M1 of the gap d1 matters. As described above, the outside air at room temperature that has flowed in through the replacement-gas supply portion 25 rises along the heaters H, and the temperature thereof is also gradually increased. If each heater H and the side wall 22h of the vaporizer body 20 are close to each other and the distance (width M1) therebetween is smaller than a thickness δ of a temperature boundary layer T, the replacement gas flowing along the heaters H and having a temperature increased by the heaters H comes into contact with the side wall 22h of the vaporizer body 20. In this case, the temperature of the side wall 22h is affected by the heaters H.

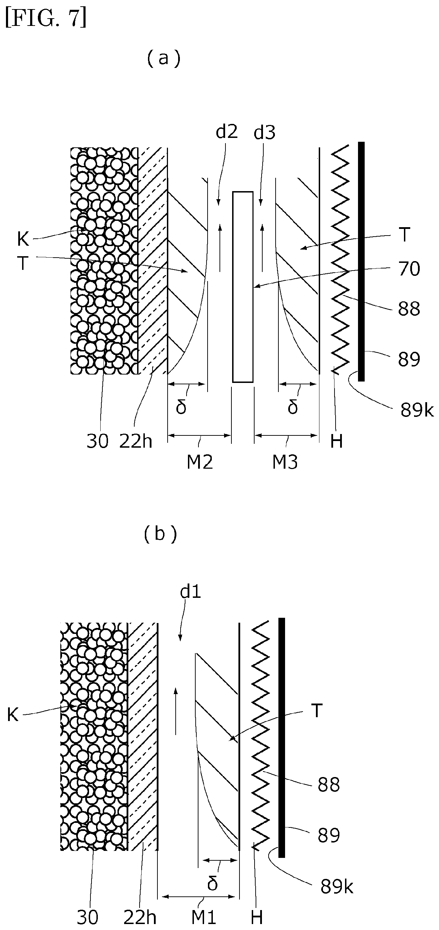

Therefore, as shown in FIG. 7(b), if the distance (width M1) between each heater H and the side wall 22h of the vaporizer body 20 is larger than the thickness δ of the temperature boundary layer T, replacement gas having a temperature that has not been increased flows along the side wall 22h between the side wall 22h and the temperature boundary layer T having an increased temperature, and blocks the thermal influence of the temperature boundary layer T having the increased temperature. Thus, the influence of the temperature boundary layer T having the increased temperature in the space in which the heaters H are disposed is assuredly eliminated.

The temperature detector 70 includes a temperature sensing element 71 and an infrared absorber 78. Regarding the temperature sensing element 71, a pair of thermocouple wires 71a, 71b, which are the temperature sensing element 71, are embedded in a stainless-steel sheath 74 with an insulating layer 72 therebetween. In the present embodiment, the sheath-shaped infrared absorber 78 is fitted so as to enclose a junction 73 of the thermocouple wires 71a, 71b and to adhere to the sheath 74. Graphite having a higher thermal conductivity than metals is used as the infrared absorber 78. The infrared absorber 78 is preferably made thinner to increase its sensitivity to variations in the absorbed infrared radiation.

As shown in FIG. 2, the temperature detector 70 is disposed between the vaporizer body 20 and the heater H, with gaps d2, d3 having widths M2, M3 provided so as to be in contact with neither the vaporizer body 20 nor the heater H.

In the vaporizer body 20, particularly in the straight tube portion 22f on the inlet side of the vaporization unit 22, the liquid material LM that has passed through the porous filter 23f flows downward between the spheres 30 in one or more meandering streams (flow paths R). When the heat energy of the infrared radiant emitted by the heaters H is sufficient for the liquid material LM, the liquid material LM is fully vaporized in the straight tube portion 22f on the inlet side. In contrast, when the heat energy of the infrared radiant emitted by the heaters H is insufficient for the liquid material LM, the liquid material LM is not fully vaporized in the straight tube portion 22f on the inlet side, and the unvaporized portion of the liquid material LM accumulate in the bent portion 22e.

A portion in which the liquid material LM is flowing or has accumulated has a lower temperature than other portions. Thus, if the temperature detector 70 is installed at this portion, a lower temperature is detected.

When the temperature detector 70 is installed so as to be in contact with neither the vaporizer body 20 nor the heater H, the temperature detector 70 is not affected by either the vaporizer body 20 or the heater H. The temperature detector 70 is heated by absorbing the infrared radiation emitted by the heater H, and detects the amount of the infrared radiation emitted by the heater H.

Strictly speaking, the widths M2, M3 of the gaps d2, d3 matter. As described above, the reflective member 28 encloses the vaporizer body 20 and the heaters H. Outside air rises along the heaters H, and the temperature of the interior of the reflective member 28, and temperature of the side wall 22h of the vaporizer body 20 are gradually increased. Even when, as described above, low-temperature outside air flows into the interior of the reflective member 28 through the replacement-gas supply portion 25 of the reflective member 28, passes through the above-described gaps d2, d3, and flows out through the replacement-gas discharge portion 26 at the ceiling, if the infrared absorber 78 of the temperature detector 70 is close to the heater H and the side wall 22h of the vaporizer body 20 and the distances (widths M2, M3) therebetween are each smaller than the thickness δ of the temperature boundary layer T as in the above, replacement gas having an increased temperature comes into contact with the infrared absorber 78. In this case, the temperature measurement by the temperature detector 70 is affected.

As shown in FIG. 7(a), if the gaps d2, d3 (widths M2, M3) are each larger than the thickness δ of the temperature boundary layer T, replacement gas having a temperature that has not been increased flows along the infrared absorber 78 between the infrared absorber 78 and the temperature boundary layer T having an increased temperature, and prevents the temperature boundary layer T having the increased temperature from thermally affecting the temperature detector 70.

Thus, the influence of the temperature boundary layer T having the increased temperature in the space in which the infrared absorber 78 is disposed is assuredly eliminated. As a result, accurate temperature measurement can be performed on the heater H.

As described above, since each heater coil 88 is covered by the transparent quartz tube 80 in the heater H, the temperature detector 70 cannot be installed on the heater coil 88. If the temperature detector 70 is installed on the transparent quartz tube 80, the transparent quartz tube 80 may be damaged. Thus, the temperature detector 70 cannot be installed on the transparent quartz tube 80.

The temperature detector 70 is connected to an external infrared heater temperature controller 90. The infrared heater temperature controller 90 is connected to a power supply 91, and is configured to control the power supplied to the heater H according to the output from the temperature detector 70.

Next, a method for vaporizing the liquid material LM using the vaporizer 10 of the present invention will be described. When power is supplied to the heater H, infrared radiation having a spectrum with a peak wavelength of 2.6 µm, including mid-infrared radiation in the range of approximately 1.5 µm to 4 µm, and forming a mountain-shaped distribution that extends toward both the short-wavelength side and the long-wavelength side, is emitted radially from the heater coil 88.

On the surface side of the heater H facing the vaporizer body 20, a considerable portion of the infrared radiation travels toward the vaporizer body 20. The infrared radiation emitted to the back-surface side is reflected by the auxiliary reflective member 89 located at the rear of the heater H (or by the cylindrical main reflective member 28 if the auxiliary reflective member 89 is not provided), and then travels toward the vaporizer body 20.

Since the vaporizer body 20 is made of transparent quartz glass that transmits infrared radiation, the infrared radiation that travels toward the vaporizer body 20 passes through the side wall 22h of the vaporizer body 20 while being refracted. Since spheres 30 are loaded inside the vaporizer body 20, the infrared radiation that has reached the vaporization space K inside the vaporizer body 20 passes through these spheres 30 while being refracted, reaches the side wall 22h on the opposite side, and further passes through the side wall 22h while being refracted. To avoid complicating the drawings, the infrared radiation is shown by straight lines.

Most of the infrared radiation that has passed through the vaporizer body 20 is reflected by the mirror surface 28k, on the opposite side, of the cylindrical reflective member 28, and again passes through the vaporizer body 20. The rest of the infrared radiation is reflected by the auxiliary reflective member 89. The infrared radiation instantaneously and infinitely repeats the above inside the cylindrical reflective member 28.

As described above, since reflection is repeated instantaneously and infinitely, the infrared radiation in the vaporization space K of the vaporizer body 20 is uniform. When the vaporization space K is heated and reaches a uniform temperature at a set temperature, which enables the liquid material LM to be vaporized, the liquid material LM is supplied into the liquid material supply unit 12. The liquid material LM flows downward onto the porous filter 23f on the inlet side through the liquid material supply unit 12. The liquid material LM that has flowed downward permeates the porous filter 23f and seeps out from the lower surface. The spheres 30 are in contact with the lower surface of the porous filter 23f, and the liquid material LM that has seeped out flows downward randomly along the surfaces of the spheres 30 in one or more streams (flow paths R).

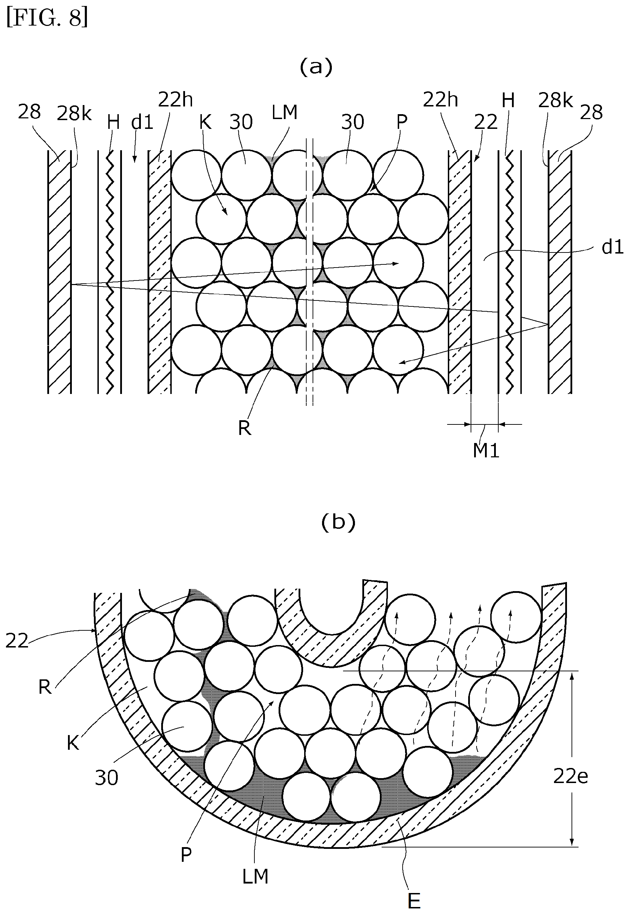

The adjacent spheres 30 are in point contact and support one another, voids P are formed therebetween, and each void P has an approximately triangular shape in a plan view and a surface formed by complicated spherical concavities. (FIG. 8(a)). Most of the flowing liquid material LM flows downward while wetting the surfaces of the spheres 30, and the rest of the liquid material LM accumulates in the voids P due to the surface tension of the liquid material LM, so that a liquid film of the liquid material LM is formed. When the thickness of the film of the liquid material LM is 10 µm or more, the film efficiently absorbs mid-infrared radiation in the range of 2.5 µm to 4 µm. In particular, when the thickness of the film is 1 mm or more, the film absorbs approximately 100% of the mid-infrared radiation.

Most of the infrared radiation used here is mid-infrared, and has wavelengths of 2.5 µm to 4 µm, which includes the absorption peak wavelength (3 µm) of the liquid material LM, as described above. Accordingly, some of the mid-infrared radiation that has reached the vaporization unit 22 is absorbed by the thin film of the liquid material LM formed on the surfaces of the spheres 30, or is absorbed by the liquid film of the liquid material LM that has accumulated in the voids P and converted into heat to vaporize the liquid material LM. When the thickness of the thin film of the liquid material LM is too small, the infrared radiation passes through unchanged. Since the spheres 30 are made of transparent quartz glass that transmits infrared radiation, the infrared radiation that has not been absorbed by the liquid material LM passes through the spheres 30 and exits to the opposite side.

The infrared radiation that has not been absorbed by the liquid material LM passes through the spheres 30 loaded in the vaporizer body 20 one after another, and passes through the side wall 22h on the opposite side of the vaporizer body 20 to radiate outward. The infrared radiation that has radiated from the vaporizer body 20 is reflected by the mirror surface 28k on the opposite side of the reflective member 28 (otherwise, is reflected by the auxiliary reflective member 89), and again travels toward the vaporizer body 20. Thus, the liquid material LM flowing downward in the vaporization space K (i.e., the straight tube portion 22f on the inlet side) is primarily heated by uniform mid-infrared radiation, and the liquid material LM that has absorbed the mid-infrared radiation and has increased in temperature, is gradually vaporized. On the other hand, heating of the liquid material LM by heat transfer from the spheres 30 via point contacts is small.

When the feed rate of the liquid material LM is low, as described above, the liquid material LM is fully vaporized in the straight tube portion 22f on the inlet side before reaching the bent portion 22e. The source gas VG obtained through vaporization sharply increases in volume, passes through the bent portion 22e and the straight tube portion 22g on the outlet side, and is discharged through the source gas discharge unit 40 toward a subsequent step.

When the feed rate of the liquid material LM is high, or when the feed rate of the liquid material LM fluctuates during the vaporization process and exceeds the heat capacity of the heater H, the liquid material LM is not fully vaporized in the straight tube portion 22f on the inlet side, and the remaining unvaporized portion of the liquid material LM accumulates in the bent portion 22e. This bent portion 22e serves as the liquid pool E.

The liquid material LM that has accumulated in the liquid pool E is exposed to infrared radiation and heated, and is vaporized in the narrow voids P between the spheres 30. Meanwhile, the inflow of the unvaporized liquid material LM into the bent portion 22e continues. Since the liquid pool E is provided, leakage of the unvaporized liquid material LM is prevented, and efficient and rapid vaporization is allowed to continue.

Since the straight tube portion 22g on the outlet side is provided between the liquid pool E and an outlet 40d of the vaporizer body 20 and there is a distance therebetween, the source gas VG rising from the liquid pool E is uniformly heated therebetween regardless of the amount.

Next, temperature measurement will be described. As described above, the liquid material LM flows downward along the surfaces of the spheres 30, is gradually vaporized, and forms one or more streams that flow downward in the straight tube portion 22f on the inlet side. When the flow rate is high and the liquid material LM accumulates in the liquid pool E, which is the bent portion 22e, the temperature of this part is lower than that of the spheres 30 or the bent portion 22e. Thus, the temperature of the part in contact with the liquid material LM naturally becomes lower than that of the part not in contact with the liquid material LM. That is, temperature non-uniformity occurs in the straight tube portion 22f on the inlet side and the bent portion 22e.

The temperature detector 70 is maintained out of contact with the vaporization unit 22 and the heater H (at least, at a distance equal to or larger than the temperature boundary layer δ), and thus is not affected by temperature non-uniformity or the heater H.

Since the temperature detector 70 has the infrared absorber 78 made of graphite as a sheath-shaped outer layer, the infrared radiation that has entered the infrared absorber 78 is almost fully absorbed and converted into heat, and the infrared absorber 78 is subjected to temperature detection. The amount of the absorbed infrared radiation is proportional to the amount of the infrared radiation emitted by the heater H. Thus, when the temperature of the infrared absorber 78 is measured, the amount of the infrared radiation emitted by the heater H can be accurately measured.

In other words, the temperature detection by the temperature detector 70 relies solely on the infrared radiation absorbed by the infrared absorber 78, independent of heat transfer, and thus the temperature detector 70 is unaffected by temperature non-uniformity in the vaporization unit 22 or by the heater H and is allowed to perform accurate temperature measurement. When the infrared absorber 78 is made as thin as possible, heat transfer to the junction 73 of the temperature detector 70 becomes faster, thereby improving temperature control responsiveness.

### (Modification 1 of embodiment 1: FIG. 9)

In the above example, the liquid material LM is supplied directly into the vaporizer body 20, but may be supplied in the form of mist. In this case, the main part of the liquid material supply unit 12 is configured as the atomizer 12a. At the center of the atomizer 12a, a liquid material supply pipe 12b is provided, and a leading end thereof is tapered into a conical shape to form a spray port 12d. A carrier gas supply pipe 12c is provided to the side surface of the atomizer 12a. A carrier gas supply path 12e that leads to the spray port 12d and that exerts a venturi effect is provided to the outer periphery of the liquid material supply pipe 12b. A space from the spray port 12d to the porous filter 23f on the inlet side forms an atomization space S. No sphere 30 is loaded in the atomization space S.

The liquid material LM is supplied into the liquid material supply pipe 12b, and the carrier gas CG is supplied into the carrier gas supply pipe 12c. This causes the venturi effect to occur, and the liquid material LM is uniformly sprayed in the form of mist through the spray port 12d into the atomization space S. The liquid material LM in the form of mist that has been sprayed into the atomization space S evenly falls onto the porous filter 23f, and flows downward toward the spheres 30 in one or more streams. The subsequent process is the same as in the embodiment 1.

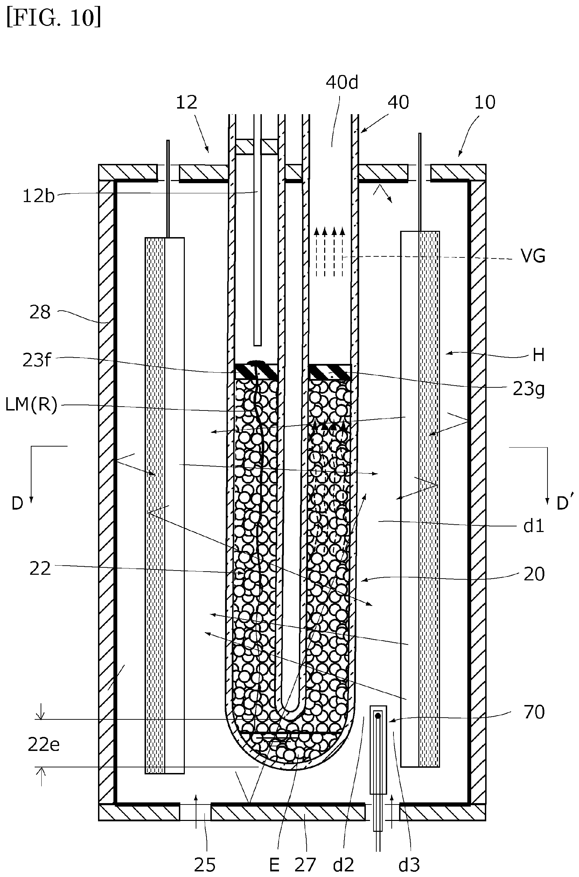

### (Embodiment 2: FIG. 10 and FIG. 11)

In an embodiment 2, compared to the embodiment 1, the shapes of the vaporizer body 20 and the reflective member 28, and the positions of the heaters H relative to the vaporizer body 20, are different.

In FIG. 3, the heaters H are installed so as to stand at the front and back of the vaporizer body 20. In contrast, in this modification, the heaters H are installed so as to stand on both sides of the vaporizer body 20. As a result, the front-to back width of the vaporizer 10 is reduced, and the reflective member 28 is allowed to be formed in a rectangular shape thin in the front-to back width, thereby enabling the vaporizer 10 to be made thinner. Due to this change, the liquid material supply unit 12 and the source gas discharge unit 40 connected to the straight tube portions 22f, 22g extend upward beyond the ceiling plate 21. The temperature detector 70 is installed between straight tube portion 22f or 22g on the inlet side or the outlet side and one of the heaters H. Other aspects are the same as in the embodiment 1.

### (Embodiment 3: FIG. 12)

In an embodiment 3, the vaporizer body 20 is provided with the bent portion 22e positioned lower than and between the straight tube portions 22f, 22g that horizontally extend. The liquid material LM that has flowed through the voids P between the spheres 30 in the straight tube portion 22f on the inlet side, flows into the liquid pool E, which is the bent portion 22e, when the flow rate is high. Then, the liquid material LM is heated and vaporized in the bent portion 22e. This aspect is the same as in the embodiment 1.

In FIG. 12, the bent portion 22e is formed in a small U-shape configuration. However, in the embodiment 2, the shape of the bent portion 22e is not limited thereto, the bent portion 22e may be connected to the straight tube portions 22f, 22g such that the lower surface at the junction thereof bulges downward in a hemispherical shape, and this bulging portion may serve as the liquid pool E. The excess portion of the liquid material LM that flows in through the straight tube portion 22f in the inlet side accumulates in the liquid pool E.

### (Embodiments 4, 5: FIG. 13 and FIG. 14)

In an embodiment 4, the vaporizer body 20 is formed by bending a transparent quartz tube into an approximately n-shaped configuration. In an embodiment 5, the vaporizer body 20 is formed by bending a transparent quartz tube into a W-shaped configuration.

In this case, the path from the liquid pool E to the outlet 40d can be made longer than that in embodiment 1, and thus uniform heating of the source gas VG can be further promoted. Other aspects are the same as in the embodiment 1.

### (Embodiment 6: FIG. 15)

In an embodiment 6, the vaporizer body 20 is formed by bending a transparent quartz tube into a helical configuration, and is disposed such that helical portion is in a horizontal orientation, and the heaters H are disposed at the center of the helical portion. In this case as well, a plurality of the bent portions 22e are provided at the helical portion, which can further promote uniform heating of the source gas VG. In this case, the first bent portion 22e serves as the liquid pool E. In this case as well, since the path from the liquid pool E to the outlet 40d can be made longer than that in the embodiment 1, uniform heating of the source gas VG can be further promoted. Other aspects are the same as in the embodiment 1.

### Reference Signs List

CG carrier gas
d1, d2, d3 gap
E liquid pool
H heater
K vaporization space
LM liquid material
M1, M2, M3 width of gap
P void
R flow path
S atomization space
T temperature boundary layer
VG source gas
δ thickness of temperature boundary layer
10 vaporizer
12 liquid material supply unit
12a atomizer
12b liquid material supply pipe
12c carrier gas supply pipe
12e carrier gas supply path
12d spray port
20 vaporizer body
21 ceiling plate
22 vaporization unit
22e bent portion
22f, 22g straight tube portion
22h side wall
23f, 23g porous filter
25 replacement-gas supply portion
26 replacement-gas discharge portion
27 bottom plate
28 reflective member
28k mirror surface
30 sphere
40 source gas discharge unit
40d outlet
70 temperature detector
71 temperature sensing element
71a, 71b thermocouple wire
72 insulating layer
73 junction
74 sheath
78 infrared absorber
80 transparent quartz tube
82, 83 sealing insulator
85, connection terminal
88 heater coil
89 auxiliary reflective member
89k mirror surface
90 infrared heater temperature controller
91 power supply

## Claims

1. A vaporizer 10 comprising:
a vaporizer body 20 that includes
a liquid material supply unit 12 that supplies a liquid material LM for semiconductor manufacturing,
a vaporization unit 22 that has therein a vaporization space K for vaporizing the supplied liquid material LM, and
a source gas discharge unit 40 that feeds a source gas VG obtained through vaporization to a subsequent step;
spheres 30 that are loaded in the vaporization unit 22; and
a heater H that emits infrared radiation to vaporize the liquid material LM, wherein
the heater H is disposed so as to be spaced from the vaporization unit 22 by a gap d1 having a width M1,
the vaporization unit 22 and the spheres 30 are formed of transparent members that transmit infrared radiation, and
a liquid pool E into which the liquid material LM flows is provided in the vaporization unit 22 so as to be positioned lower than flow paths R of the liquid material LM flowing through the vaporization space K.

2. The vaporizer according to claim 1, wherein the vaporization unit 22 is formed of a bent tube member.

3. The vaporizer according to claim 1, further comprising a reflective member 28 that is disposed outside the heater H so as to enclose the vaporization unit 22, and that has an inner surface facing the vaporization unit 22 and formed as a mirror surface 28k that reflects infrared radiation.

4. The vaporizer according to claim 1 or 3, wherein
an auxiliary reflective member 89 is provided on a surface of the heater H that faces away from the vaporizer body 20, and
a surface of the auxiliary reflective member 89 that reflects infrared radiation toward the vaporizer body 20 is a mirror surface 89k.

5. The vaporizer according to claim 1 or 3, wherein
a temperature detector 70 that measures an amount of infrared radiation is disposed between the vaporization unit 22 and the heater H such that gaps d2, d3 having widths M2, M3 are provided between the temperature detector 70 and the vaporizer body 20 and between the temperature detector 70 and the heater H.

6. The vaporizer according to claim 5, wherein
the temperature detector 70 includes
an infrared absorber 78 that is made of graphite and that is heated by absorbing infrared radiation, and
a temperature sensing element 71 that is embedded in the infrared absorber 78 and that detects temperature of the infrared absorber 78.
